(19) Europäisches Patentamt / European Patent Office / Office européen des brevets

(11) **EP 3 079 227 A1**

(12) **EUROPEAN PATENT APPLICATION**
published in accordance with Art. 153(4) EPC

(43) Date of publication:
**12.10.2016 Bulletin 2016/41**

(51) Int Cl.:
*H02J 13/00* (2006.01)    *G01R 21/00* (2006.01)
*G06F 1/28* (2006.01)    *H02J 3/00* (2006.01)

(21) Application number: **14868647.0**

(22) Date of filing: **28.07.2014**

(86) International application number:
**PCT/JP2014/069868**

(87) International publication number:
**WO 2015/083397 (11.06.2015 Gazette 2015/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.12.2013 JP 2013251240**

(71) Applicant: **Kabushiki Kaisha Toshiba**
**Minato-ku**
**Tokyo 105-8001 (JP)**

(72) Inventors:
• **WADA, Takahisa**
  **Tokyo 105-8001 (JP)**
• **KUBOTA, Kazuto**
  **Tokyo 105-8001 (JP)**
• **KATAYAMA, Kyosuke**
  **Tokyo 105-8001 (JP)**

(74) Representative: **Hoffmann Eitle**
**Patent- und Rechtsanwälte PartmbB**
**Arabellastraße 30**
**81925 München (DE)**

(54) **CALCULATION DEVICE**

(57) According to an embodiment, an operation apparatus includes a feature waveform extraction unit (13) which extracts a feature waveform before and after a change time point at which the operating state of an instrument changes. The operation apparatus includes an operation unit (14) which performs an operation for decomposing feature waveforms into one or more frequency components. The operation apparatus includes an instrument feature database unit (15) which stores frequency features representing operating states of a predetermined instrument. The operation apparatus includes a harmonic weighted-distance calculator (16) which calculates a weighted distance, on polar coordinates, between an operation result and a feature stored in the instrument feature database unit (15), the weighted distance being calculated for each operating state. The operation apparatus includes an operating state estimation unit (17) which estimates operating states of an instrument, based on the weighted distance.

FIG. 2

EP 3 079 227 A1

## Description

Technical Field

Embodiments described herein relate to an operation apparatus.

Background Art

There is technology that individually measures the operating state of an inverter-incorporated electric appliance used at home. Instead of installing a measuring instrument for each electric appliance, the technology estimates the operating state of each electric appliance in a non-invasive manner by measuring how each electric appliance operates based on the condition of the incoming line from an electric pole to a house.

The technology pays special attention to the fundamental waves and harmonic currents generated by electric appliances and the phases corresponding to the voltages. Based on the measurement data on voltages and currents measured in the neighborhood of the lead-in port of the feeding line, the technology individually estimates the operating state of each electric appliance by applying a neural network or the like.

An apparatus for reliably checking the ON/OFF operation of an electric appliance and estimating the type of electric appliance in the loaded condition is also known in the art. Based on the electricity quantity detection results detected at a measuring point of the feeding line, the apparatus detects which electric appliance is in the load state from among a plurality of electric appliances located downstream of the measurement point and connected through a switch means, and estimates the type of electric appliance in the load state for which the switch means is closed.

An appliance state detector is also known in the art, which accurately detects the operating states of electric appliances with no need to learn the combinations of the operating states of electric appliances to be detected.

The appliance state detector calculates the feature amount of each frequency component based on the measurements of currents and voltages. To identify electric appliances, the appliance state detector searches a database in which identification information for identifying the electric appliances, feature amounts and operating states are associated with one another. The appliance state detector compares calculated feature amounts with the feature amounts stored in the database, determines whether the calculated feature amounts are identical to those stored in the database, and identifies the electric appliances based on the determination.

According to the above-mentioned technology to which a neural network is applied, the combinations of operating states of all household appliances have to be reflected in the neural network by learning. This preparatory operation takes time and requires a memory of large storage capacity in order to store an enormous amount of pattern data.

The technology for estimating the type of electric appliance in the load state has problems in that the accuracy for estimation may be lowered when an unknown electric appliance is newly installed and operated.

The appliance state detector described above performs an operation in each cycle, and the amount of operation is inevitably large. In addition, the appliance state detector does not exclude waveforms generated when an operating state is changing. In other words, the appliance state detector estimates the type of electric appliance in the load state by using waveforms which are generated when the operating state is changing and which therefore have unstable phases. As a result, the number of false detection increases.

[Prior Art Reference]

[Patent Literature]

[Patent Literature 1]
Jpn. Pat. Appln. KOKAI Publication No. 2000-292465
[Patent Literature 2]
Jpn. Pat. Appln. KOKAI Publication No. 2002-152971
[Patent Literature 3]
Jpn. Pat. Appln. KOKAI Publication No. 2012-189526

SUMMARY OF INVENTION

An object of the present invention is to provide an operation apparatus capable of detecting the operating state of an appliance with high accuracy.

An operation apparatus according to an embodiment includes a measuring unit which measures an electrical quantity of an appliance at intervals and outputs time-series data on the measured electrical quantity. The operation apparatus includes a detector which detects a change time point at which the operating state of an appliance changes, based on the measured time-series data. The operation apparatus includes a feature waveform extraction unit which extracts feature waveforms indicating how the operating state of an appliance changes before and after the change time point, based on the detected change time point and the measured time-series data. The operation apparatus includes an operation unit which performs an operation for decomposing feature waveforms extracted by the feature waveform extraction unit into one or more frequency components. The operation apparatus includes (i) an appliance feature database storing a feature which a predetermined appliance exhibits at each frequency and which is therefore indicative of an operating state of the appliance, and (ii) a harmonic weighted-distance calculator which calculates a weighted distance on polar coordinates between an operation result of the operation unit and a frequency feature stored in the appliance feature database, the weighted distance being calculated in each operating state. The operation apparatus includes an operating state estimation unit which estimates operating states of an appliance undergoing the operation change, based on the weighted distance which the harmonic weighted-distance calculator calculates for each operating state.

Brief Description of Drawings

FIG. 1 is a block diagram illustrating a configuration example of a general type of operation apparatus used for detecting the state of an appliance;
FIG. 2 is a block diagram showing a configuration example of the operation apparatus of the first embodiment;
FIG. 3 is a flowchart illustrating an example of an operation performed by the operation apparatus of the first embodiment;
FIG. 4 shows an example of data that are processed by the operation apparatus of the first embodiment;
FIG. 5 is a flowchart illustrating an example of a step in which the operation apparatus of the first embodiment detects a change time point of an operating state of an appliance;
FIG. 6 shows an example of data which the operation apparatus of the first embodiment processes to detect a change time point of an operating state of an appliance;
FIG. 7 is a flowchart illustrating an example of a step in which the operation apparatus of the first embodiment estimates the operating state of an appliance;
FIG. 8 shows an example of data which the operation apparatus of the first embodiment processes to estimate the operating state of the appliance;
FIG. 9 illustrates a method in which the operation apparatus of the first embodiment extracts a feature waveform;
FIG. 10 illustrates an example of a method by which the general-type of operation apparatus calculates a harmonic distance so as to detect a state of an appliance;
FIG. 11 shows an example of a method in which the operation apparatus of the first embodiment calculates a harmonic weighted distance;
FIG. 12 illustrates an example of a power consumption estimation model employed by the operation apparatus of the

first embodiment; and

FIG. 13 is a block diagram showing a configuration example of an operation apparatus of a server/local structure according to the second embodiment.

Mode for Carrying Out the Invention

A description will now be given of embodiments with reference to the accompanying drawings.

(First Embodiment)

First, the first embodiment will be described.

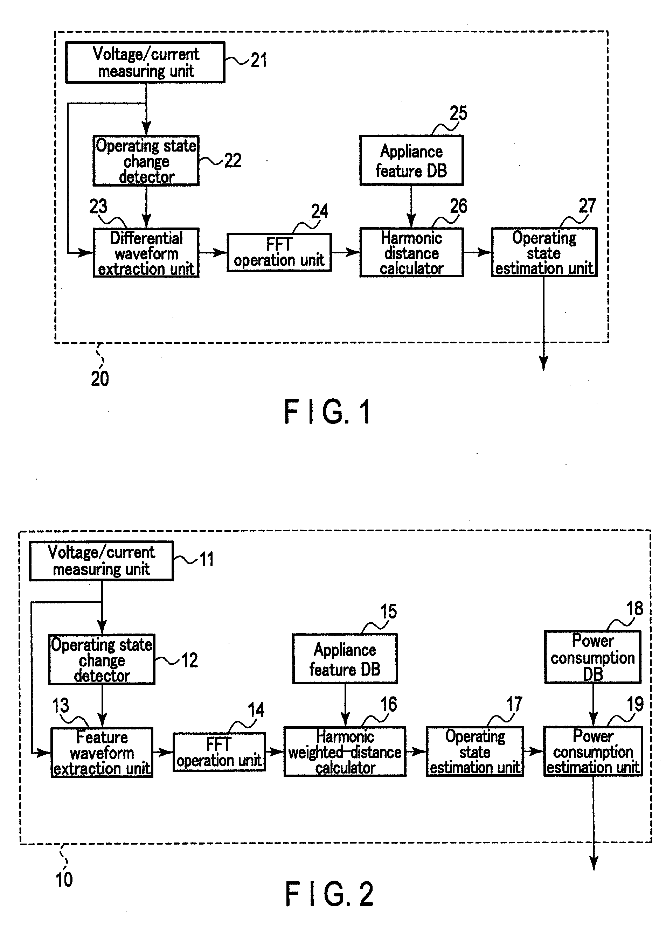

FIG. 1 is a block diagram illustrating a configuration example of a general type of operation apparatus used for detecting the state of an appliance.
The operation apparatus 20 shown in FIG. 1 functions as an appliance state detector for detecting the state of an electric appliance, such as a household electric appliance. The electric appliance such as the household electric appliance may be referred to simply as an appliance.
The operation apparatus 20 comprises a voltage/current measuring unit 21, an operating state change detector 22, a differential waveform extraction unit 23, an FFT (fast Fourier transformation) operation unit 24, an appliance feature DB (database) 25, a harmonic distance calculator 26, and an operating state estimation unit 27.

The voltage/current measuring unit 21 measures the voltage and current of an appliance at regular intervals and outputs time-series data on the measured voltage and current.

The operating state change detector 22 receives the time-series data from the voltage/current measuring unit 21 and detects a change time point at which the operating state of an appliance changes, based on the time-series data.

The change time point of the operating state of an appliance is a time point at which the operating state of that appliance changes. The change in the operating state of an appliance shown in FIG. 1 is a change which the appliance undergoes when the power supply thereof is switched from ON to OFF or from ON to OFF.

The differential waveform extraction unit 23 extracts a differential current waveform before and after the change time point, based on the change time point detected by the operating state change detector 22 and the time-series data supplied from the voltage/current measuring unit 21.

The FFT operation unit 24 calculates a harmonic FFT coefficient of the differential current waveform by performing an FFT for the differential current waveform detected by the differential waveform extraction unit 23.

The appliance feature DB 25 is a storage medium, such as a nonvolatile memory. The appliance feature DB 25 stores harmonic FFT coefficients, which are coefficients corresponding to the features of the operating states of the respective appliances.

The harmonic distance calculator 26 calculates a harmonic distance between an FFT coefficient calculated by the FFT calculator 24 and an FFT coefficient corresponding to each operating state. The FFT coefficient corresponding to each operating state is stored in the appliance feature DB 25.

The operating state estimation unit 27 selects an operating state corresponding to the shortest distance, based on the harmonic distances which the harmonic distance calculator 26 calculates for the respective operating states. The operating state estimation unit 27 outputs the selected operating state as an estimation result of the operating state of an appliance.

A description will now be given of the operation apparatus of the first embodiment.

FIG. 2 is a block diagram showing a configuration example of the operation apparatus of the first embodiment.

The operation apparatus 10 shown in FIG. 2 functions as both an appliance state detector and a power consumption estimation unit for an appliance.

The operation apparatus 10 comprises a voltage/current measuring unit 11, an operating state change detector 12, a feature waveform extraction unit 13, an FFT operation unit 14, an appliance feature DB 15, a harmonic weighted-distance calculator 16, an operating state estimation unit 17, a power consumption DB 18, and a power consumption estimation unit 19.

The operation apparatus 10 shown in FIG. 2 differs from the operation apparatus 20 shown in FIG. 1 in that the differential waveform extraction unit 23 is replaced with the feature waveform extraction unit 13 and the harmonic distance calculator 26 is replaced with the harmonic weighted-distance calculator 16.

The operation apparatus 10 shown in FIG. 2 further differs from the operation apparatus 20 shown in FIG. 1 in that the power consumption DB 18 and the power consumption estimation unit 19 are added.

The voltage/current measuring unit 11 measures the voltage and current of an appliance (such as a household electric appliance) at regular intervals and outputs time-series data on the measured voltage and current.

The operating state change detector 12 receives the time-series data from the voltage/current measuring unit 11 and detects a discontinuous point in the time-series data. The operating state change detector 12 detects the time point corresponding to the discontinuous point as a time point at which the operating state of an appliance changes.

The change in the operating state of an appliance shown in FIG. 2 is a change which the appliance undergoes when the power supply thereof is switched from ON to OFF or from Off to ON. In the case where the appliance is a washing machine, the change corresponds to an operation mode change, such as the change from "washing" to "rinsing." The operating state may change at a plurality of time points.

The feature waveform extraction unit 13 extracts a feature current waveform before and after the change time point, which is a waveform indicative of a change in the operating state of an appliance, based on the change time point detected by the operating state change detector 12 and the time-series data supplied from the voltage/current measuring unit 11. The FFT operation unit 14 calculates a harmonic FFT coefficient of the feature current waveform by performing an FFT for the feature current waveform detected by the feature waveform extraction unit 13.

The appliance feature DB 15 is a storage medium, such as a nonvolatile memory. The appliance feature DB 15 stores harmonic FFT coefficients, which are coefficients corresponding to the features of the operating states of the respective appliances.

The harmonic weighted-distance calculator 16 calculates a weighted distance between an FFT coefficient calculated by the FFT operation unit 14 and an FFT coefficient corresponding to the feature of each operating state. The FFT coefficient corresponding to the feature of each operating state is stored in the appliance feature DB 15.

Based on the weighted distance which the harmonic weighted-distance calculator 16 calculates for each operating state, the operating state estimation unit 17 selects an operating state corresponding to the shortest weighted distance, and outputs the selected operating state as an estimation result of the operating state of an appliance.

The power consumption DB 18 is a storage medium, such as a nonvolatile memory. The power consumption DB 18 stores a regression model. The regression model is prepared based on the relationships between a feature corresponding to each operating state of an appliance and a power consumption by an appliance corresponding to the feature.

Based on the operating state output from the operating state estimation unit 17, the power consumption estimation unit 19 reads from the power consumption DB 15 the regression model corresponding to the appliance for which the operating state is estimated, and outputs an estimation result based on the regression model as an estimation result of that appliance.

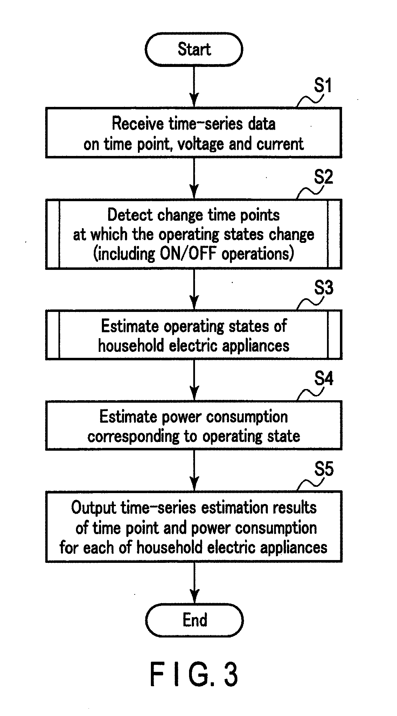

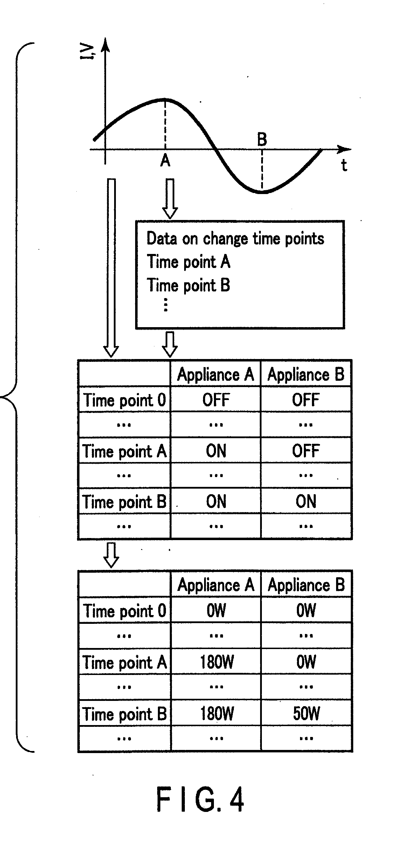

FIG. 3 is a flowchart illustrating an example of an operation performed by the operation apparatus of the first embodiment. FIG. 4 shows an example of data that are processed by the operation apparatus of the first embodiment.

The voltage/current measuring unit 11 measures the voltage (V) and current (I) of an appliance at regular intervals and outputs time-series data on the measured voltage and current.

The operating state change detector 12 receives the time-series data from the voltage/current measuring unit 11 (step S1).

Based on the time-series data, the operating state change detector 12 detects change time points (FIG. 4) at which the operating states of appliances change (step S2). In FIG. 4, the appliances are indicated as appliance A and appliance B. The operating state change detector 12 adds change time points of the operating states of the appliances to the time-series data supplied from the voltage/current measuring unit 11, and supplies the resultant data to the feature waveform extraction unit 13.

A description will now be given of how the operating state of an appliance is estimated.

The feature waveform extraction unit 13 receives time-series data supplied from the voltage/current measuring unit 11 and also receives change time points of operating states detected in step S2. The feature waveform extraction unit 13 extracts the feature current waveform detected before and after a change time point.

The operating state estimation unit 17 estimates which appliance (e.g., a household electric appliance) undergoes an operating state change (step S3), based on a weighted distance. The weighted distance is a distance between an FFT result corresponding to the feature current waveform detected before and after a change time point in operating state and an FFT coefficient stored in the appliance feature DB 15.

Where the operating state changes twice or more, the operating state estimation unit 17 performs similar processing for all change time points.

In this manner, the operating state estimation unit 17 obtains time-series estimation results of time points and operating states for each of the appliances. The operating state estimation unit 17 supplies the power consumption estimation unit 19 with time points corresponding to the changes in the operating states and the time-series estimation results of operating states, for each of the appliances.

Then, the power consumption estimation unit 19 receives time-series estimation results of operating states for each of the appliances from the operating state estimation unit 17. The power consumption estimation unit 19 receives a power consumption estimation model corresponding to the operating state from the power consumption DB 15. Based on the received time-series estimation results and power consumption estimation model, the power consumption estimation unit 19 searches for a power consumption corresponding to the operating state which is represented by the model and which is the same as the operating state represented by the received time-series estimation results. In this manner, the power consumption estimation unit 19 estimates a power consumption of an appliance for which the operating state is estimated. As a result, time-series estimation results of power consumption are obtained (step S4).

The power consumption estimation unit 19 supplies the estimation results, along with the change time point of the operating state of the appliance, to a display (not shown) (step S5).

Next, steps S2 to S4 will be described in detail.

First, step S2 will be described in detail.

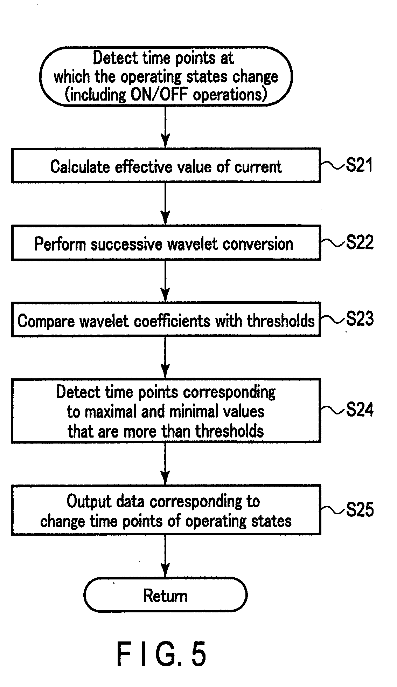

FIG. 5 is a flowchart illustrating an example of a step in which the operation apparatus of the first embodiment detects a change time point of an operating state of an appliance. All operations related to step S2 are performed by the operating state change detector 12.

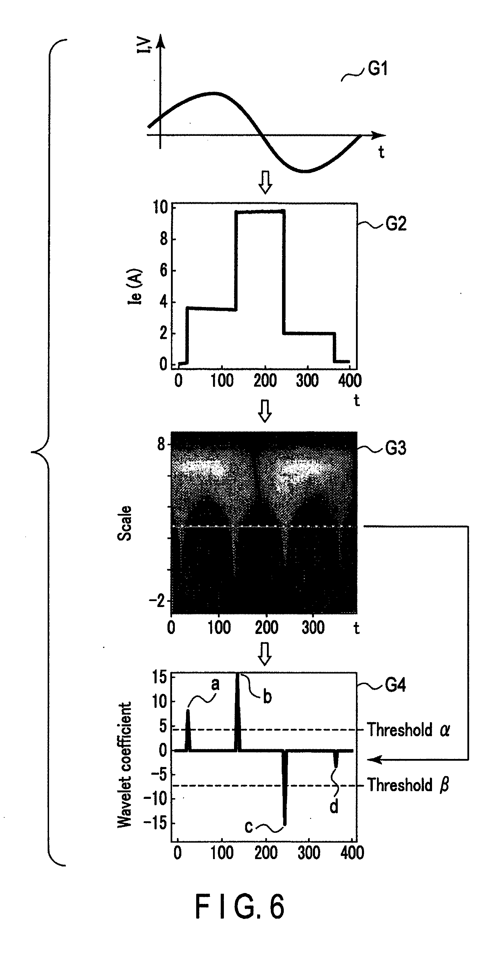

FIG. 6 shows an example of data which the operation apparatus of the first embodiment processes to detect a change time point of an operating state of an appliance.

As shown in FIG. 5, the step for detecting the change time point of the operating state includes steps S21 to S24.

First, the operating state change detector 12 calculates effective value Ie (G2 shown in FIG. 6) of the current based on the time-series data (G1 shown in FIG. 6) of the current supplied from the voltage/current estimation unit 11 (step S21).

The effective value may be calculated at any intervals. The shorter the intervals are, the higher will be the time resolution for estimating the operating state of an appliance or for estimating the power consumption. However, the amount of operation is inevitably large, accordingly. On the other hand, if the time intervals are long, the false detection rate may lower, but since a state change cannot be detected, the estimation accuracy will decrease.

As indicated by G3 in FIG. 6, the operating state change detector 12 subjects successive wavelet conversion to the time-series data of the current effective value (step S22).

By this conversion, the operation apparatus can detect a current change of an appliance, as shown in FIG. 6. By detecting this change, the operation apparatus can detect all changes of the operating state of an apparatus, including ON/OFF operations of the appliance, a power consumption change of an inverter-incorporated household electric appliance, and an operating mode change of a continuously-operated household electric appliance.

As indicated by G4 in FIG. 6, the operating state change detector 12 detects wavelet coefficients in the direction of the time axis in a predetermined scale, and compares the wavelet coefficients (a, b, c and d shown in FIG. 6) with predetermined thresholds ($\alpha$ and P shown in FIG. 6 (step S23). In FIG. 6, G4 indicates a section of the successive wavelet conversion results of a predetermined scale.

The value of the scale can be any value desired. The scale is a coefficient that increases or decreases the wavelet basis function.

Where the scale is small, the wavelet coefficients vary in response to a current variation whose time constant is small. Where the scale is large, the wavelet coefficients vary in response to a current variation whose time constant is large. It should be noted that where the scale is large, the wavelet coefficients do not vary in response to a current variation whose time constant is small.

Therefore, the operation apparatus can control the time constants of current variations to be detected by adjusting the scale. The values of the wavelet coefficients are related to current variations. The operation apparatus can control the current variations by determining thresholds and comparing wavelet coefficients with the thresholds.

A wavelet coefficient having a positive value indicates a current increase. A wavelet coefficient having a negative value indicates a current decrease.

In other words, a current increase can be detected by setting a threshold at a positive value, and a current decrease can be detected by setting a threshold at a negative value.

The timing when the operating state of an appliance changes corresponds to the time point at which a wavelet coefficient is maximal. The operating state change detector 12 detects the time points corresponding to vertexes a and b in the graph G4 in FIG. 6 (at which the wavelet coefficients are larger than threshold $\alpha$) as the time points when the coefficients are maximal.

The operating state change detector 12 detects the time point corresponding to vertex c in the graph G4 in FIG. 6 (at which the wavelet coefficient is smaller than threshold P) as the time point when the coefficient is minimal.

The operating state change detector 12 outputs these time points as time points when the operating state of an appliance changes. When the operating state of an appliance changes can be output not only where the operating state changes once but also where it changes a number of times (a, b, c and d in G4 of FIG. 6).

Next, step S3 will be described in detail.

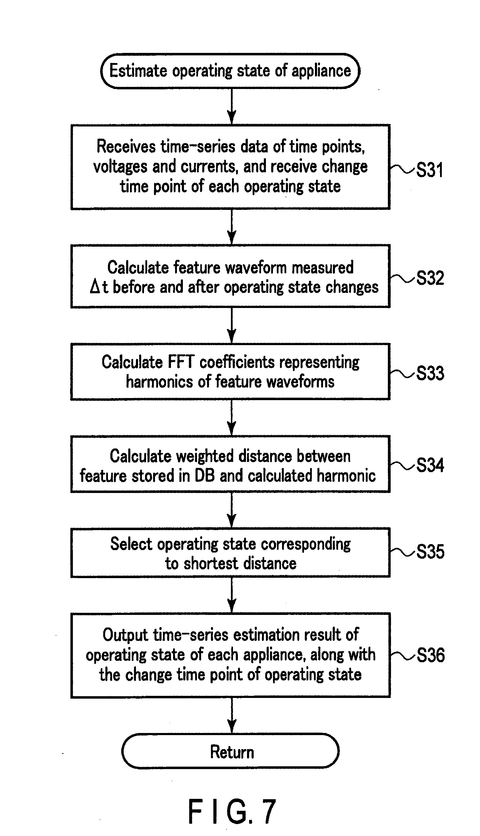

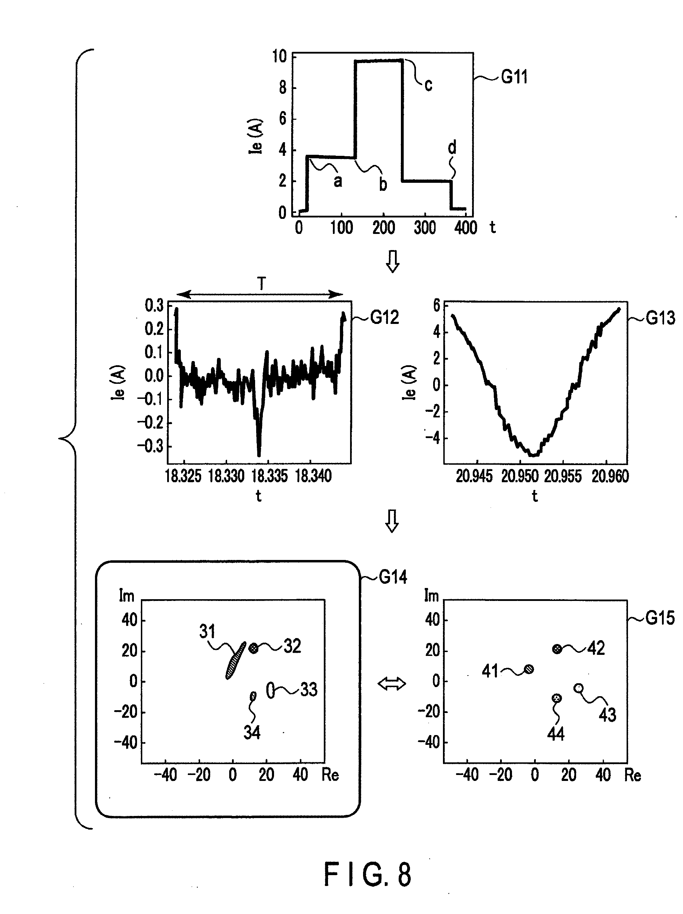

FIG. 7 is a flowchart illustrating an example of a step in which the operation apparatus of the first embodiment estimates the operating state of an appliance. FIG. 8 shows an example of data which the operation apparatus of the first embodiment processes to estimate the operating state of the appliance. The step is performed by the feature waveform extraction unit 13, the harmonic weighted-distance calculator 16 or the operating state estimation unit 17.

As shown in FIG. 7, the step for estimating the operating state of an appliance includes steps S31 to S36.

The feature waveform extraction unit 13 receives time-series data of voltages and currents from the voltage/current measuring unit 11 and receives a change time point of an operating state (G11 in FIG. 8) from the operating state change detector 12 (step S31). The feature waveform extraction unit 13 calculates a feature waveform, which is a waveform measured before and after the operating state changes (step S32). The feature waveform extraction unit 13 supplies this waveform to the FFT operation unit 14, along with the change time point of the operating state supplied from the operating state change detector 12.

Since the waveform tends to be unstable when the operating state is changing, the feature of that waveform may be hard to detect. In step S32, therefore, the feature waveform extraction unit 13 does not process the waveform generated when the operating state is changing. To be more specific, the feature waveform extraction unit 13 compares a current waveform X (G12 shown in FIG. 8) obtained $\Delta t$ before time point <u>a</u> when the operating state changes with a current waveform Y (G13 shown in FIG. 8) obtained $\Delta t$ after time point a. In order to prevent the feature waveform extraction unit 13 from referring to the waveform generated when the operating state is changing, $\Delta t$ has to be changed dynamically in consideration of the time coefficient of the operating state change. Time T in G12 is 20 ms (one wavelength).

According to the present embodiment, two methods are selectively used for extracting a feature waveform after a waveform obtained $\Delta t$ before a change time point a waveform obtained $\Delta t$ after the change time point are compared with each other.

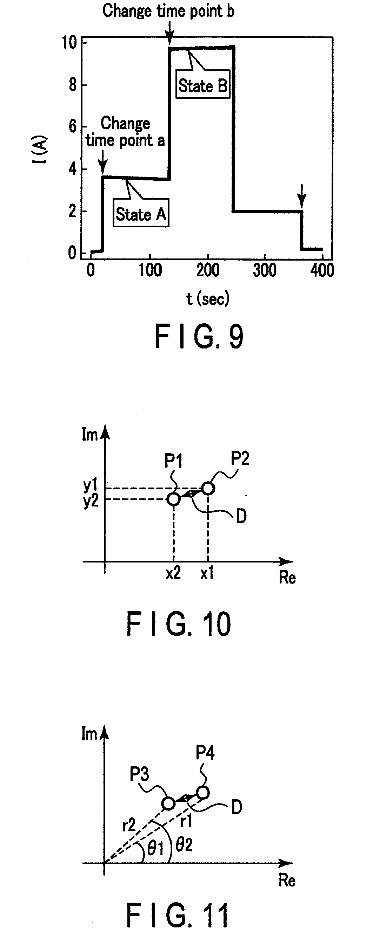

FIG. 9 illustrates a method in which the operation apparatus of the first embodiment extracts a feature waveform.

A first method for extracting a feature waveform will be described. When the operating state of an appliance is changed from OFF to ON by turning on the power supply (which state is depicted in FIG. 9 as an operating state change from state a to state A), the operation apparatus extracts a differential component of the waveforms obtained before and after change time point a, and uses it as a feature waveform of state A.

The feature waveform extraction unit 13 obtains a feature waveform of a current by referring to the feature waveform of a voltage and detecting a waveform when the phase of the voltage becomes 0. The feature waveform extraction unit 13 adjusts the phase of a fundamental waveform by referring to the voltage. As a result of this processing, the phase change of the fundamental waveform can be used as reference information when the operating state is estimated.

When the operating state of the appliance changes from state A to state B (which state change is depicted in FIG. 9 as an operating state change at change time point b), a differential component of the waveforms obtained before and after change time point b may be obtained, but this differential component is not a current waveform corresponding to state B.

Assuming that N appliances are operating in the ON condition, a description will be given of how a feature waveform is extracted before and after a change time point.

In order to determine changes in the operating states of the N appliances in the ON state, the feature waveform extraction unit 13 extracts a feature waveform before and after a change time point. This feature waveform is a combination of differential components between a waveform obtained with respect to a predetermined appliance after a change time point and waveforms of (N-1) appliances in operation (appliances other than the predetermined one).

In order to evaluate all possible operating state changes in a step performed later, this step extracts feature waveforms of all appliances based on the assumption that the operating states of all appliances change.

A description will be given of how a change in the operating state of an ON operating state appliance is determined.

By way of example, let us assume that a plurality of appliances (N appliances) are in operation and that the operating state of one of the appliances changes from state A to state B. A feature waveform for detecting this state change is given by:

$$\text{(feature waveform used for detecting state B)} =$$
$$\text{(waveform obtained } \Delta t \text{ after a change time point)} -$$
$$\text{(synthetic waveform of (N-1) operating appliances} \quad \dots \quad (1)$$

Let us assume that the operating state of one of devices 1, 2 ... N may have changed and that the operating state of ON-state appliance 1 changes from state A to state B. In this case, the feature waveform extraction unit 13 determines whether or not the operating state of appliance 1 changes, based on the waveform given by:

$$\text{(extracted waveform)} = \text{(waveform of appliance 1}$$
$$\text{obtained } \Delta t \text{ after a change time candidate)} - \text{(synthetic}$$
$$\text{waveform of the operating waveforms of appliances 2, 3} \dots$$
$$\text{N that are in the ON state)} \quad \dots \quad (2)$$

Let us assume that the operating state of ON-state appliance 2 changes from state A to state B. In this case, the feature waveform extraction unit 13 determines whether or not the operating state of appliance 2 changes, based on the waveform given by:

$$\text{(extracted waveform)} = \text{(waveform of appliance 2}$$
$$\text{obtained } \Delta t \text{ after a change time point candidate)} -$$
$$\text{(synthetic waveform of the operating waveforms of}$$
$$\text{appliances 1, 3} \dots \text{N that are in the ON state)} \quad \dots \quad (3)$$

Let us assume that the operating state of ON-state appliance N changes from state A to state B. In this case, the feature waveform extraction unit 13 determines whether or not the operating state of appliance N changes, based on the waveform given by:

$$\text{(extracted waveform) = (waveform of appliance N}$$

$$\text{obtained } \Delta t \text{ after a change time point candidate)} -$$

$$\text{(synthetic waveform of the operating waveforms of}$$

$$\text{appliances 1, 2 ... (N-1) that are in the ON state) ... (4)}$$

The FFT operation unit 14 performs an FFT for all current feature waveforms extracted in step S32 so as to calculate FFT coefficients representing harmonics of the feature waveforms (step S33). The FFT operation unit 14 supplies this calculation result to the harmonic weighted-distance calculator 16, along with the change time point of the operating state supplied from the feature waveform extraction unit 13.

A description will be given of how the operation apparatus 20 calculates a harmonic distance. FIG. 10 illustrates an example of a method by which the general-type of operation apparatus calculates a harmonic distance so as to detect a state of an appliance. As shown in FIG. 10, the harmonic distance calculator 26 uses FFT results and calculates a weighted distance for each order harmonic according to Formula (5) set forth below. The weighted distance is a distance (D in FIG. 10) by which an FFT result and an FFT coefficient stored in the appliance feature DB 25 are away from each other on the Cartesian coordinates. In FIG. 10, P1 indicates an FFT coefficient stored in the appliance feature DB 25. In FIG. 10, P2 indicates a FFT result. In the example shown in FIG. 10, the FFT coefficient of the third-order harmonic is shown.

$$\text{distance = (x1-x2) + (y1-y2) ... (5)}$$

where x1 is a coordinate value on a real axis (Re) of the Cartesian coordinates and corresponds to the FFT result, x2 is a coordinate value on an imaginary axis (Im) of the Cartesian coordinates and corresponds to the FFT result, y1 is a coordinate value on the real axis of the Cartesian coordinates and corresponds to the FFT coefficient stored in the appliance feature DB 25, and y2 is a coordinate value on the imaginary axis of the Cartesian coordinates and corresponds to the FFT coefficient stored in the appliance feature DB 25.

FIG. 11 shows an example of a method in which the operation apparatus of the first embodiment calculates a harmonic weighted distance.

The harmonic distance calculator 26 accumulates the distances of the respective orders to calculate a final distance.

It should be note here that household appliances include an appliance that greatly changes the magnitude of a harmonic (not the phase of the harmonic) when the power consumption is greatly changed. If, in this case, the operation apparatus calculates a distance between the FFT coefficient stored in the appliance feature DB 25 and the FFT result obtained by the FFT operation unit 14, using the Cartesian coordinates shown in FIG. 10, the distance is inevitably long, resulting in a high false detection rate.

To solve this problem, the harmonic weighted-distance calculator 16 of the present embodiment uses polar coordinates for expressing the harmonic FFT coefficient calculated in step S33, as shown in FIG. 11, and a weighted distance (D in FIG. 11) is represented by a phase angle and an absolute value. In FIG. 11, P3 indicates the FFT coefficient stored in the appliance feature DB 25. In FIG. 11, P4 indicates the FFT result. In the example shown in FIG. 11, the FFT coefficient of the third-order harmonic is shown.

As indicated by the first term of Formula (6) set forth below, the harmonic weighted-distance calculator 16 calculates an absolute value of the difference between the value indicating how the calculated FFT coefficient is away from the point of origin on the polar coordinates and the value indicating how the FFT coefficient stored in the appliance feature DB 15 is away from the point of origin on the same polar coordinates. As indicated by the second term of Formula (6) set forth below, the harmonic weighted-distance calculator 16 calculates an absolute value of the difference between the phase angle of the calculated FFT coefficient indicated on the polar coordinates and the phase angle of the FFT coefficient in the appliance feature DB 15 indicated on the polar coordinates (step S34).

As shown by Formula (6) set forth below, the harmonic weighted-distance calculator 16 multiplies each calculation result by predetermined weight coefficients $\alpha$ and $\beta$, thereby obtaining a final weighted distance. The harmonic weighted-distance calculator 16 supplies this calculation result to the operating state estimation unit 17, along with the change time point of the operating state supplied from the FFT operation unit 14.

$$Distance = \alpha*abs(r1-r2) + \beta*abs(\theta1-\theta2) \ldots (6)$$

where r1 is a distance by which an FFT result is away from the point of origin on the polar coordinates, r2 is a distance by which a feature stored in the appliance feature DB 15 is away from the point of origin on the polar Coordinates, θ1 is a phase (deflection angle) by which the FFT result is away from the real axis of the polar coordinates, θ2 is a phase by which the feature stored in the appliance feature DB 15 is away from the real axis of the polar coordinates, and α and are given values.

The values of α and β may be varied in accordance with the feature of the operations of appliances. If importance should be placed on the phase, the value of β may be increased.

In the example indicated by G14 in FIG. 8, a third-order harmonic FFT coefficient 31, a fifth-order harmonic coefficient 32, a seventh-order harmonic coefficient 33 and a seventh-order harmonic FFT coefficient 34 are shown as features of the operating states stored in the appliance feature DB 15. The FFT coefficients 31, 32, 33 and 34 are stored in the appliance feature DB 15.

In the example indicated by G15 in FIG. 8, FFT coefficients representing FFT operation results are shown. The FFT coefficients are specifically a third-order harmonic FFT coefficient 41, a fifth-order harmonic coefficient 42, a seventh-order harmonic coefficient 43 and a ninth-order harmonic FFT coefficient 44.

In this example, the distance between FFT coefficient 31 and FFT coefficient 41 on the same coordinates is a third-order harmonic weighted distance, and the distance between FFT coefficient 32 and FFT coefficient 42 on the same coordinates is a fifth-order harmonic weighted distance. The distance between FFT coefficient 33 and FFT coefficient 43 on the same coordinates is a seventh-order harmonic weighted distance, and the distance between FFT coefficient 34 and FFT coefficient 44 on the same coordinates is a ninth-order harmonic weighted distance.

Next, the operating state estimation unit 17 compares the weighted distances of each appliance calculated in step S34, and selects an operating state corresponding to the shortest distance (step S35). The operating state estimation unit 17 outputs this operating state as an estimation result of the operating state of an appliance, along with the change time point of the operating state supplied from the harmonic weighted-distance calculation unit 16 (step S36).

In this manner, the operation apparatus 10 can output a time point corresponding to the change time point of the operating state of an appliance and time-series estimation result of an operating state, for each of the appliances (e.g., household electric appliances).

A description will now be given of how the power consumption is estimated in accordance with the operating state of an appliance.

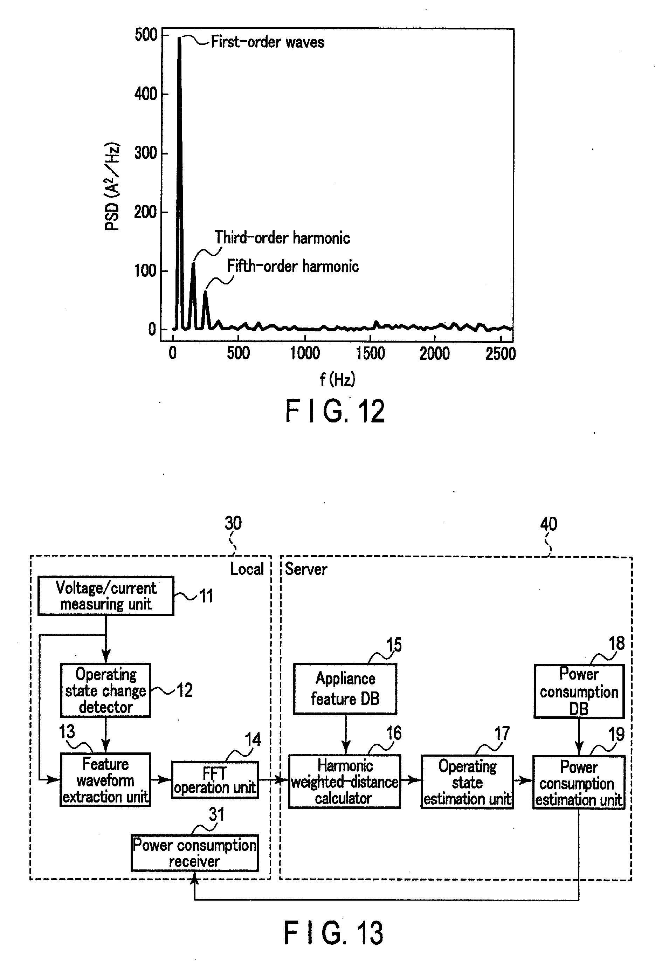

FIG. 12 illustrates an example of a power consumption estimation model employed by the operation apparatus of the first embodiment. In FIG. 12, frequency (f) characteristics of a power spectral density are shown.

Based on the time-series estimation result of the operating state of an appliance, the power consumption estimation unit 19 reads a power consumption model corresponding to the operating state from the power consumption DB 18.

As shown in FIG. 12, the power consumption of an appliance is highly correlated with the order of a harmonic, especially a small-order power spectral density (PSD). Utilizing this correlation, the present embodiment employs a regression model in which a harmonic power spectral density and power consumption are associated with each other. To be specific, most of the current is made up of components of fundamental waves (first-order waves), third-order waves, fifth-order waves and seventh-order waves. Therefore, the power consumption of an appliance can be represented as a regression model of the fundamental waves and third-order, fifth-order and seventh-order harmonics.

An example of a regression model is represented by Formula (7) set forth below. Such a regression model is determined for each operating state of each appliance.

Estimated Value of Power

$$Estimated\ Value\ of\ Power\ Consumption = 8.93 + 2.2e\text{-}$$
$$3*mamo3 + 2.273e\text{-}3*mamo5 + 4.172e\text{-}3*mamo7 - 4.108e\text{-}$$
$$8*mamo3*mamo5 - 2.047e\text{-}7*mamo3*mamo7 - 4.308e\text{-}7*mamo5*mamo7$$
$$+ 5.859e\text{-}12*mamo3*mamo5*mamo7 \ldots (7)$$

where mamo3 is a third-order harmonic power spectral density, mamo5 is a fifth-order harmonic power spectral density, and mamo7 is a seventh-order harmonic power spectral density.

In step S3, a change time point of an operating state and an estimation result of the operating state are output from the operating state estimation unit 17. Based on the harmonic information on the appliance corresponding to the estimated operating state, the power consumption estimation unit 19 calculates a power spectral density of the appliance for which the operating state is estimated. Based on this power spectral density and the regression model, the power consumption estimation unit 19 calculates consumption power of the appliance for which the operating state is estimated.

As described above, the operation apparatus of the present embodiment estimates the operating state of an appliance in operation.

Because a weighted distance on the polar coordinates are used for the estimation of an operating state, the operation apparatus of the present embodiment reduces false detection of the operating state of an appliance that changes the magnitude of a current while maintaining the phase.

As described above, the operation apparatus of the present embodiment reduces false detection in the estimation of an operating state and enables estimation of the power consumption of an appliance.

(Second Embodiment)

The second embodiment will be described. Of the constituent elements of the second embodiment, the constituent elements which are similar to those of the first embodiment will not be described in detail.

FIG. 13 is a block diagram showing a configuration example of an operation apparatus of a server/local structure according to the second embodiment.

As shown in FIG. 13, according to the second embodiment, the operation apparatus described in relation to the first embodiment is divided into a server and a local.

To be specific, the local (client) 30 comprises a voltage/current measuring unit 11, an operating state change detector 12, a feature waveform extraction unit 13 and an FFT operation unit 14. The server 40 comprises an appliance feature DB 15, a harmonic weighted-distance calculator 16, an operating state estimation unit 17, a power consumption DB 18 and a power consumption estimation unit 19.

The local 30 also comprises a power consumption receiver 31. According to the second embodiment, a plurality of locals 30 are provided for one server 40, and the server 40 and the locals 30 are connected to each other to enable bidirectional communications.

With this structure, each local 30 can send the operation result of the FFT operation unit 14 to the server 40 by way of a network.

Based on the operation result of the FFT operation unit 14, the operating state estimation unit 17 of the server 40 estimates an operating state corresponding to the shortest weighted distance.

The power consumption estimation unit 19 of the server 40 estimates a power consumption of an appliance, and the server 40 transmits the result of this estimation to the power consumption receiver 31 of the local 30 so that the result can be displayed.

The second embodiment having this configuration is advantageous in that it can reduce the hardware cost on the side of a local.

Even if FFT coefficients stored in databases and regression models used for the estimation of power consumption are changed in the server, this does not necessitate any change in the locals. Accordingly, the contents of the databases can be changed flexibly.

If the hardware of the server deteriorates with time, it is simply repaired or replaced with another. The cost for the repair or replacement can be as low as possible.

As described above, at least one of the embodiments provides an operation apparatus capable of detecting the operating state of an appliance with high accuracy.

Note that the method described in each of the aforementioned embodiments can be stored in a storage medium such as a magnetic disk (a floppy® disk, a hard disk, or the like), an optical disk (a CD-ROM, a DVD, or the like), a magneto-optical disk (MO), or a semiconductor memory as a program executable by a computer, and can be distributed.

Any storage format may be adopted as long as the storage medium can store a program, and is readable by the computer.

An OS (Operating System) operating on the computer, MW (middleware) such as database management software or network software, or the like may execute part of each process for implementing the aforementioned embodiments based on the instruction of the program installed from the storage medium to the computer.

The storage medium according to each of the embodiments is not limited to a medium independent of the computer, and also includes a storage medium that stores or temporarily stores the program transmitted by a LAN, the Internet, or the like by downloading it.

The number of storage media is not limited to one. The storage medium according to the present invention also incorporates a case in which the processing of each of the aforementioned embodiments is executed from a plurality of media, and the media can have any arrangement. Note that the computer according to each of the embodiments is configured to execute each process of each of the aforementioned embodiments based on the program stored in the storage medium, and may be, for example, a single device formed from a personal computer or a system including a plurality of devices connected via a network.

The computer according to each of the embodiments is not limited to a personal computer, and also includes an arithmetic processing device or microcomputer included in an information processing apparatus. The term "computer" collectively indicates apparatuses and devices capable of implementing the functions of the present invention by the program.

While a certain embodiment has been described, this embodiment has been presented by way of example only, and is not intended to limit the scope of the inventions. Indeed, the novel embodiment described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

Reference Signs List

11... Voltage/current measuring unit; 12... Operating state change detector; 13... Feature waveform extraction unit; 14... FFT operation unit; 15... Appliance feature DB; 16... Harmonic weighted-distance calculator; 17... Operating state estimation unit; 18... Power consumption DB; 19... Power consumption estimation unit; 21... Voltage/current measuring unit; 22... Operating state change detector; 23... Differential waveform extraction unit; 24... FFT operation unit; 25... Appliance feature DB; 26... Harmonic distance calculator; 27... Operating state estimation unit; 30... Local31... Power consumption receiver; 40... Server

**Claims**

1. An operation apparatus **characterized by** comprising:

   a measuring unit (11) which measures an electrical quantity of an appliance at regular intervals and outputs time-series data on measured electrical quantity;
   a detector (12) which detects a change time point at which an operating state of the appliance changes, based on the time-series data;
   a feature waveform extraction unit (13) which extracts a feature waveform indicating how the operating state of the appliance changes before and after the change time point, based on a detected change time point and the time-series data;
   an operation unit (14) which performs an operation for decomposing the feature waveform extracted by the feature waveform extraction unit (13) into one or more frequency components;
   an appliance feature database (15) which stores frequency features representing operating states of a predetermined appliance;
   a harmonic weighted-distance calculator (16) which calculates a weighted distance, on polar coordinates, between an operation result of the operation unit (14) and a frequency feature stored in the appliance feature database (15), the weighted distance being calculated for each operating state; and
   an operating state estimation unit (17) which estimates an operating state of an appliance undergoing an operation change, based on the weighted distance which the harmonic weighted-distance calculator (16) calculates for each operating state.

2. The operation apparatus according to claim 1, **characterized by** further comprising:

   a power consumption database (18) which stores information in which a harmonic feature representing the operating state of the predetermined appliance and power consumption of the predetermined appliance are correlated with each other; and
   a power consumption estimation unit (19) which estimates power consumption of an appliance the operating state of which is estimated, based on a harmonic feature of an appliance whose operating state is estimated by the operating state estimation unit (17) and information stored in the power consumption database (18).

3. The operation apparatus according to claim 1, **characterized in that** the detector (12) detects a discontinuous point of the time-series data and uses the discontinuous point as a change time point at which the operating state changes.

4. The operation apparatus according to claim 1, **characterized in that** the detector (12) detects a plurality of change time points at which the operating state changes.

5. The operation apparatus according to claim 1, **characterized in that** the feature waveform extraction unit (13) extracts a difference between a current waveform after the change time point and a current waveform before the change time point and uses the difference to extract the feature waveform of an appliance which is turned on or off.

6. The operation apparatus according to claim 1, **characterized in that** a plurality of appliances are in operation, and the feature waveform extraction unit (13) calculates a difference between a current waveform obtained from a selected appliance after the change time point and a synthetic waveform of current waveforms obtained from a plurality of appliances in operation other than the selected appliance, and extracts the difference as a feature waveform representing that the selected appliance in operation changes from a first state to a second state.

7. The operation apparatus according to claim 5, **characterized in that** the feature waveform extraction unit (13) regards the current waveform before the change time point as a waveform obtained a predetermined short time before the change time point, and extracts the feature waveform, with the short time being changed dynamically.

8. The operation apparatus according to claim 5 or claim 6, **characterized in that** the feature waveform extraction unit (13) regards the current waveform after the change time point as a waveform obtained a predetermined short time after the change time point, and extracts the feature waveform, with the short time being changed dynamically.

9. The operation apparatus according to claim 1, **characterized in that** the operation unit (14) performs a fast Fourier transformation for a feature waveform detected by the feature waveform extraction unit (13) so as to convert components of the feature waveform into frequency components, and uses a harmonic coefficient represented by the components obtained by the fast Fourier transformation as the operation result.

10. The operation apparatus according to claim 1, **characterized in that**
   when a distance between a feature which the operation unit (14) represents at each frequency and a feature which the appliance feature database (15) stores for each frequency is calculated, and the features are plotted on a polar coordinate format, the harmonic weighted-distance calculator (16) calculates (i) a distance difference between a distance by which a feature which the operation result represents for each frequency is away from a point of origin and a distance by which a feature stored for each frequency is away from the point of origin, and (ii) an angle difference between a phase angle of the feature which the operation result represents for each frequency and a phase angle of the feature stored for each frequency, calculates a first value by multiplying an absolute value of the distance difference by a predetermined coefficient and a second value by multiplying an absolute value of the angle difference by a predetermined coefficient, and uses a sum of the first value and the second value as a weighted distance between an operation feature represented by the operation result and an operation feature stored in the appliance feature database unit (15).

11. The operation apparatus according to claim 1, **characterized in that** the operating state estimation unit (17) selects an operating state corresponding to a shortest distance included in weighted distances calculated by the harmonic weighted-distance calculator (16) and outputs the operating state as an estimation result of an operating state of the appliance.

12. The operation apparatus according to claim 2, **characterized in that** the consumption power database (18) stores a regression model in which a harmonic feature corresponding to an operating state of each appliance and consumption power of an appliance corresponding to the harmonic feature are associated with each other.

13. The operation apparatus according to claim 2, **characterized in that** the regression model stored in the consumption power database (18) describes a harmonic power spectrum corresponding to an operating state of each appliance as a harmonic feature corresponding to the operating state of each appliance.

14. The operation apparatus according to claim 2, **characterized in that**:

   a server (40) and a client (30) are provided,
   the client (30) includes the measuring unit (11), the detector (12) and the operation unit (14),

the server (40) includes the appliance feature database (15), the harmonic weighted-distance calculator (16), the operating state estimation unit (17), the power consumption database (18) and the power consumption estimation unit (19), and
the client (30) receives an estimation result obtained by the power consumption estimation unit (19) and displays the estimation result.

F I G. 1

F I G. 2

Start

Receive time-series data
on time point, voltage and current
S1

Detect change time points
at which the operating states change
(including ON/OFF operations)
S2

Estimate operating states of
household electric appliances
S3

Estimate power consumption
corresponding to operating state
S4

Output time-series estimation results
of time point and power consumption
for each of household electric appliances
S5

End

# F I G. 3

Data on change time points
Time point A
Time point B
⋮

|  | Appliance A | Appliance B |
|---|---|---|
| Time point 0 | OFF | OFF |
| ... | ... | ... |
| Time point A | ON | OFF |
| ... | ... | ... |
| Time point B | ON | ON |
| ... | ... | ... |

|  | Appliance A | Appliance B |
|---|---|---|
| Time point 0 | 0W | 0W |
| ... | ... | ... |
| Time point A | 180W | 0W |
| ... | ... | ... |
| Time point B | 180W | 50W |
| ... | ... | ... |

F I G. 4

Detect time points at
which the operating states change
(including ON/OFF operations)

Calculate effective value of current ~S21

Perform successive wavelet conversion ~S22

Compare wavelet coefficients with thresholds ~S23

Detect time points corresponding
to maximal and minimal values
that are more than thresholds ~S24

Output data corresponding to
change time points of operating states ~S25

Return

F I G. 5

FIG. 6

Estimate operating state of appliance

Receives time-series data of time points, voltages and currents, and receive change time point of each operating state ⎯ S31

Calculate feature waveform measured Δt before and after operating state changes ⎯ S32

Calculate FFT coefficients representing harmonics of feature waveforms ⎯ S33

Calculate weighted distance between feature stored in DB and calculated harmonic ⎯ S34

Select operating state corresponding to shortest distance ⎯ S35

Output time-series estimation result of operating state of each appliance, along with the change time point of operating state ⎯ S36

Return

F I G. 7

F I G. 8

Change time point b

10

8

State B

6

I (A)

Change
time point a

4

State A

2

0

0    100    200    300    400

t (sec)

## F I G. 9

Im

P1    P2

y1

y2    D

x2    x1    Re

## F I G. 10

Im

P4

P3

r2    r1    D

θ1    θ2

Re

## F I G. 11

F I G. 12

F I G. 13

**INTERNATIONAL SEARCH REPORT**

| International application No. |
|---|
| PCT/JP2014/069868 |

A.   CLASSIFICATION OF SUBJECT MATTER
*H02J13/00*(2006.01)i, *G01R21/00*(2006.01)i, *G06F1/28*(2006.01)i, *H02J3/00*
(2006.01)i

According to International Patent Classification (IPC) or to both national classification and IPC

B.   FIELDS SEARCHED

Minimum documentation searched (classification system followed by classification symbols)
H02J13/00, G01R21/00, G06F1/28, H02J3/00-5/00

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| A | JP 2013-150508 A  (Nippon Telegraph and Telephone Corp.), 01 August 2013 (01.08.2013), claims 1 to 2; paragraphs [0015] to [0016], [0027] to [0028], [0031] to [0034], [0044] to [0052], [0060] to [0062] (Family: none) | 1-14 |
| A | JP 2013-009500 A  (Fujitsu Ltd.), 10 January 2013 (10.01.2013), claim 1; paragraphs [0033] to [0052] (Family: none) | 1-14 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 October, 2014 (06.10.14) | 14 October, 2014 (14.10.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/069868

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2000-292465 A (Central Research Institute of Electric Power Industry), 20 October 2000 (20.10.2000), paragraphs [0013] to [0017], [0035] to [0040] (Family: none) | 1-14 |
| A | JP 2002-152971 A (Daihen Corp.), 24 May 2002 (24.05.2002), paragraphs [0026] to [0032], [0055] to [0070] (Family: none) | 1-14 |
| A | JP 2012-189526 A (Mitsubishi Electric Corp.), 04 October 2012 (04.10.2012), claim 1; paragraphs [0031] to [0035], [0037] to [0039], [0053] to [0069] (Family: none) | 1-14 |

Form PCT/ISA/210 (continuation of second sheet) (July 2009)

**EP 3 079 227 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000292465 A
- JP 2002152971 A
- JP 2012189526 A